# EUROPEAN PATENT APPLICATION

(11) **EP 4 654 228 A1**
(43) Date of publication of application: **26.11.2025**
(21) Application number: 25170048.0
(22) Date of filing: 11.04.2025
(51) Int. Cl.: H01F 3/14, H01F 27/28, H01F 27/40, H01F 30/12, H02M 3/00

(54) **MODULAR STACKED MAGNETIC COMPONENT**

(30) Priority: 22.05.2024 US 202463650482 P; 07.01.2025 US 202519012408
(71) Applicant: Delta Electronics, Inc., Neihu, Taipei 11491 (TW)
(72) Inventor: Wang, Dakai, Morrisville, NC, 27560 (US); Tsai, Meng-Chi, Taoyuan City 320023 (TW); Peng, Te-Chih, Taoyuan City 320023 (TW); Kumar, Misha, Morrisville, NC, 27560 (US); Barbosa, Peter Mantovanelli, Morrisville, NC, 27560 (US)
(74) Representative: Uexküll & Stolberg

(57) **Abstract**

A modular stacked magnetic component (100) is provided. The modular stacked magnetic component (100) is for a DC-DC converter with N phases, and N is an odd number greater than 1. In the N phases, an nth phase is 360/N degrees leading an (n+1)th phase, n is a positive integer less than N, and an Nth phase is 360/N degrees leading a first phase. The modular stacked magnetic component (100) includes N magnetic cores (11, 12, 13), a magnetic cover (10), and N windings (21, 22, 23). The N magnetic cores (11, 12, 13) are stacked vertically in sequence. The magnetic cover (10) is stacked on the top of the N magnetic cores (11, 12, 13). The N windings (21, 22, 23) are connected to the N phases of the DC-DC converter respectively, and each winding (21) is wound on winding columns (111) of a corresponding magnetic core (11) to form an integrated transformer and inductor. Any two adjacent windings (21, 22) have opposite current directions.

## Description

### FIELD OF THE INVENTION

The present disclosure relates to a magnetic component, and more particularly to a modular stacked magnetic component.

### BACKGROUND OF THE INVENTION

With the fast development of information technology (IT), especially cloud computing, big data, and artificial intelligence (AI), the power consumption of data center is increasing significantly. The power level of each power supply unit needs to be increased a lot without increasing the footprint. As a result, multi-phase LLC becomes one of the good candidates for data center applications because of lower root-mean-square (RMS) and peak currents, lower current ripple on DC capacitors, and better magnetic integrations and power density. However, the integration of multi-phase transformers and inductors for high-power applications remains challenging due to flux crowding, eddy current losses, dimensional resonances, and physical size limitations.

Therefore, there is a need of providing a modular stacked magnetic component in order to overcome the drawbacks of the conventional technologies.

### SUMMARY OF THE INVENTION

The present disclosure provides a modular stacked magnetic component capable of reducing the volume of magnetic cores and the loss and achieving better flux distribution.

In accordance with an aspect of the present disclosure, a modular stacked magnetic component is provided. The modular stacked magnetic component is for a DC-DC converter with N phases, and N is an odd number greater than 1. In the N phases, an nth phase is 360/N degrees leading an (n+1)th phase, n is a positive integer less than N, and an Nth phase is 360/N degrees leading a first phase. The modular stacked magnetic component includes N magnetic cores, a magnetic cover, and N windings. The N magnetic cores are stacked vertically in sequence, each magnetic core includes a plate and a plurality of winding columns, and the plurality of winding columns are arranged on the plate. The magnetic cover is stacked on the top of the N magnetic cores. The N windings are connected to the N phases of the DC-DC converter respectively, and each of the N windings is wound on the plurality of winding columns of a corresponding magnetic core of the N magnetic cores to form an integrated transformer and inductor. Any two adjacent windings, among the N windings, have opposite current directions.

In accordance with another aspect of the present disclosure, a modular stacked magnetic component is provided. The modular stacked magnetic component is for a single-phase DC-DC converter. The modular stacked magnetic component includes a plurality of magnetic cores, a magnetic cover, and a plurality of windings. The plurality of magnetic cores are stacked vertically in sequence, each magnetic core includes a plate and at least one winding column, and the at least one winding column is arranged on the plate. The magnetic cover is stacked on the top of the plurality of magnetic cores. Each winding is wound on the at least one winding column of a corresponding magnetic core of the plurality of magnetic cores to form an integrated transformer and inductor, a transformer, or an inductor. The plurality of windings have a same current direction.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a schematic view illustrating a modular stacked magnetic component according to an embodiment of the present disclosure;
FIG. 2A is a schematic view illustrating a modular stacked magnetic component applied to a single-phase DC-DC converter;
FIG. 2B schematically shows relations between the magnetic fluxes in FIG. 2A;
FIG. 3A is a schematic view illustrating a modular stacked magnetic component applied to a DC-DC converter with three phases;
FIG. 3B schematically shows relations between the magnetic fluxes in FIG. 3A;
FIG. 4 is a schematic circuit diagram illustrating a three-phase DC-DC converter with the integrated transformer and inductor formed by the modular stacked magnetic component of the present disclosure;
FIG. 5A is a schematic view illustrating a modular stacked magnetic component applied to the three-phase DC-DC converter of FIG. 4 which operates in a light load condition;
FIG. 5B schematically shows relations between the magnetic fluxes in FIG. 5A;
FIG. 6 is a schematic circuit diagram illustrating another three-phase DC-DC converter with the integrated transformer and inductor formed by the modular stacked magnetic component of the present disclosure;
FIG. 7A, FIG. 7B and FIG. 7C exemplifies different types of magnetic cores and winding manners;
FIG. 8 is a schematic perspective view illustrating an example of the modular stacked magnetic component of FIG. 7C;
FIG. 9 is a schematic perspective view illustrating a modular stacked magnetic component including magnetic cores without side columns according to an embodiment of the present disclosure;
FIG. 10A is a schematic view illustrating a modular stacked magnetic component applied to a five-phase DC-DC converter according to an embodiment of the present disclosure;
FIG. 10B schematically shows relations between the magnetic fluxes in FIG. 10A;
FIG. 11A is a schematic view illustrating a modular stacked magnetic component applied to a five-phase DC-DC converter according to another embodiment of the present disclosure;
FIG. 11B schematically shows relations between the magnetic fluxes in FIG. 11A; and
FIG. 12A and FIG. 12B schematically show two possible implementations of a portion which forms an inductor part of the integrated transformer and inductor in FIG. 9.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

The planar transformer with PCB winding has proven effective in enabling an automated manufacturing process with high reliability. However, challenges arise when considering its integration into the Open Rack V3 (ORV3) standard, specifically for power supply units (PSUs) exceeding 5kW. The primary issues include the oversized footprint, compromised z-axis optimization, and underutilized height in the context of a one rack unit (1U) design, where the z-axis is perpendicular to the planer of the PCB.

The inventor finds the limitation of the conventional planar structures is that they didn't fully utilize the degrees of freedom provided by the decoupled electric and magnetic path of the symmetric multi-phase system. Additionally, the planar transformer sacrifices z-axis optimization freedom.

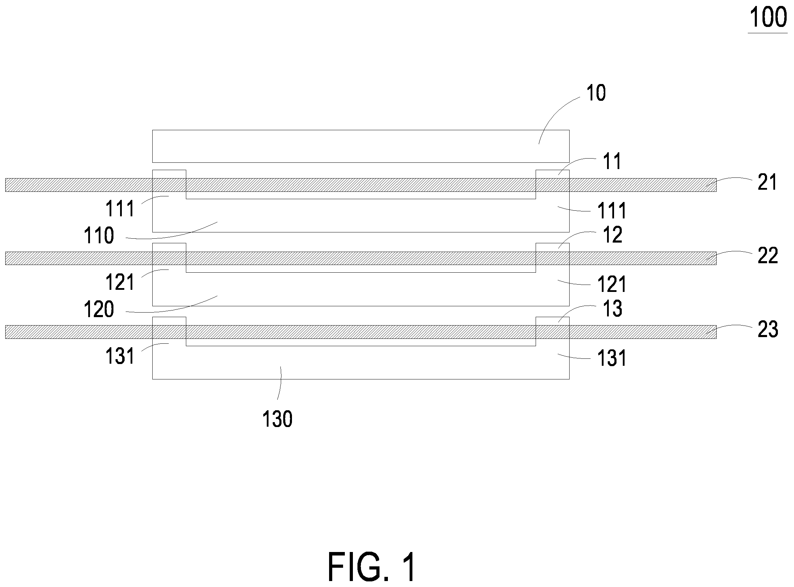

FIG. 1 is a schematic view illustrating a modular stacked magnetic component according to an embodiment of the present disclosure. As shown in FIG. 1, the modular stacked magnetic component 100 is applicable for a DC-DC converter and includes a plurality of magnetic cores (e.g., the three magnetic cores 11, 12 and 13 shown in the figure), a magnetic cover 10, and a plurality of windings (e.g., the three windings 21, 22 and 23 shown in the figure). The plurality of magnetic cores are stacked vertically on each other in sequence, and each magnetic core includes a plate (e.g., the three plates 110, 120 and 130 shown in the figure) and one or more winding columns (e.g., the side columns 111, 121 and 131 shown in the figure) arranged on the plate. In an embodiment, among any two adjacent magnetic cores, there is an air gap between the winding column(s) of one magnetic core and the plate of the other magnetic core. The magnetic cover 10 is stacked on the top of the plurality of magnetic cores. The plurality of windings are connected to the phase(s) of the DC-DC converter, and each winding is wound on one or more winding columns of a corresponding magnetic core to form an integrated transformer and inductor, a transformer, or an inductor. In some embodiments, the winding is implemented by a PCB (printed circuit board) winding or a wire winding. And when the winding is implemented by a PCB winding, the winding and the corresponding magnetic core correspondingly form an integrated planar transformer and inductor, a planar transformer, or a planar inductor.

In this embodiment, the modular stacked magnetic component 100 includes a magnetic cover 10 disposed on the top of the plurality of magnetic cores, i.e., on the top of the magnetic core 11. Conventionally, there are a plurality of magnetic covers disposed on the plurality of magnetic cores respectively, while in the present disclosure, the magnetic cover 10 only disposed on the top one of the magnetic cores. Therefore, the volume of the whole magnetic component is reduced. In an embodiment, there are air gaps between the adjacent magnetic cores (e.g., between the magnetic cores 11 and 12 and between the magnetic cores 12 and 13) and between the magnetic core 11 and the magnetic cover 10 adjacent to each other.

In addition, the modular stacked component 100 is applicable for the DC-DC converter with odd phase(s), and the number of the magnetic cores and the direction relations between currents flowing through the windings are related to the number of the phase(s) of the DC-DC converter. For instance, the number of the phase(s) of the DC-DC converter may be any odd number. When the DC-DC converter have only one phase (i.e., single phase), the number of the magnetic cores may be any integer greater than one, and all the windings have the same current direction. Alternatively, when the number of the phases of the DC-DC converter is an odd number greater than one, the number of the magnetic cores is an integer multiple of the number of the phases of the DC-DC converter, and any two adjacent windings have opposite current directions.

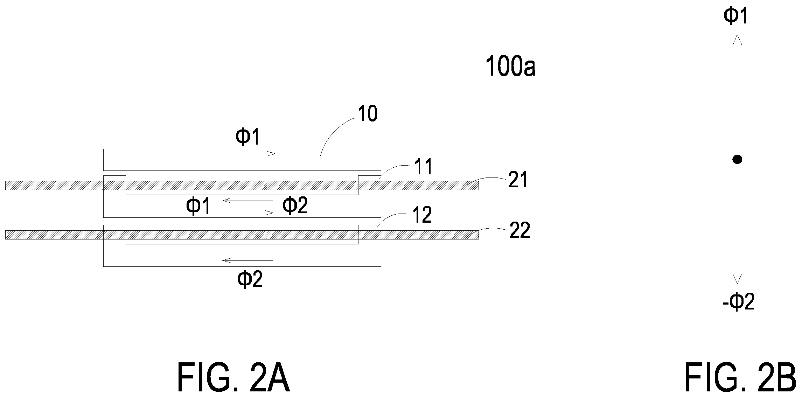

FIG. 2A is a schematic view illustrating a modular stacked magnetic component applied to a single-phase DC-DC converter. In FIG. 2A, the component parts and elements corresponding to those of FIG. 1 are designated by identical numeral references, and detailed descriptions thereof are omitted herein. As shown in FIG. 2A, the modular stacked magnetic component 100a is applied to a single-phase DC-DC converter and includes two magnetic cores 11 and 12 and two windings 21 and 22, and the two windings 21 and 22 are wound on the two magnetic cores 11 and 12 respectively. It should be noted that in single-phase DC-DC converter, the modular stacked magnetic component can include three or more magnetic cores. The currents flowing through the windings 21 and 22 respectively are from the same phase of the DC-DC converter and have the same direction. Caused by the current flowing through the winding 21, a magnetic flux Φ1 flows through the magnetic cover 10 and the magnetic core 11. Caused by the current flowing through the winding 22, a magnetic flux Φ2 flows through the magnetic cores 11 and 12. In this embodiment, since the currents have the same direction, the magnetic fluxes Φ1 and Φ2 in the magnetic core 11 have opposite directions and thus are cancelled out by each other. The relations between the magnetic fluxes Φ1 and Φ2 are shown in FIG. 2B. Moreover, since the magnetic fluxes in the magnetic core 11 are cancelled out, the thickness of the plate of the magnetic core 11 may be reduced to decrease the volume and loss of the modular stacked magnetic component 100a, and also a better flux distribution is achieved. In general, when the modular stacked magnetic component is applied to the single-phase DC-DC converter, due to the flux cancellation, the thickness of the plate of the magnetic core(s) in the middle (e.g., the magnetic core 11 in FIG. 2A) may vary from a predetermined minimum thickness with acceptable mechanical strength to the thickness of the magnetic cover 10 (or the magnetic core on the top) or the plate of the magnetic core on the bottom (e.g., the magnetic core 12 in FIG. 2A). Additionally, in an embodiment, the air gaps between the magnetic cores 11 and 12 and the magnetic cover 10 have the same size.

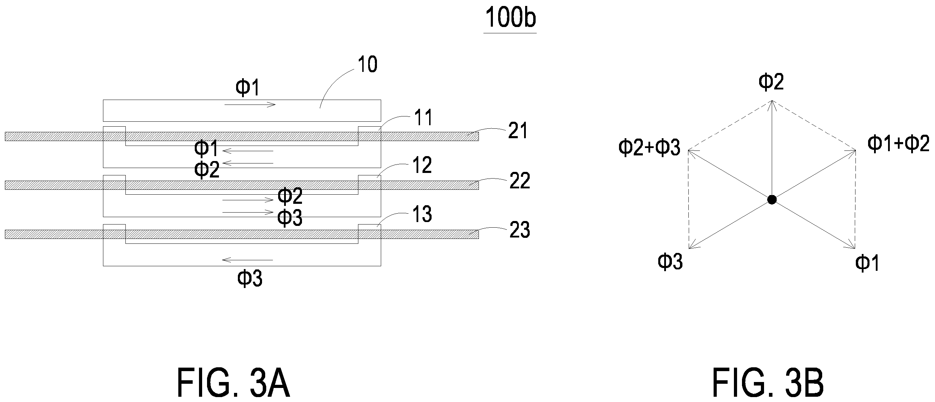

Please refer to FIG. 3A. FIG. 3A is a schematic view illustrating a modular stacked magnetic component applied to a DC-DC converter with three phases. In the present disclosure, the DC-DC converter with three phases can be expanded to a DC-DC converter with N phases, where N is an odd number greater than 1. In FIG. 3A, the component parts and elements corresponding to those of FIG. 1 are designated by identical numeral references, and detailed descriptions thereof are omitted herein. Regarding the DC-DC converter with N phases, the nth phase is 360/N degrees leading the (n+1)th phase, where n is a positive integer less than N, and the Nth phase is 360/N degrees leading the first phase. Correspondingly, the modular stacked magnetic component may include one or more sets of magnetic cores and windings, and each set includes N magnetic cores and N windings. It is noted that the N windings are connected to the N phases of the DC-DC converter respectively and are wound on the N magnetic cores respectively. Further, when the modular stacked magnetic component includes multiple sets, the multiple sets may be stacked sequentially in a direction of the magnetic cores being stacked, where the direction of the magnetic cores being stacked is set from top to bottom, for example, from the first magnetic core to the Nth magnetic core.

As shown in FIG. 3A, the modular stacked magnetic component 100b is applied to a three-phase DC-DC converter (i.e., N=3) and includes three magnetic cores 11, 12 and 13 and three windings 21, 22 and 23, and the three windings 21, 22 and 23 are wound on the three magnetic cores 11, 12 and 13 respectively. The three windings 21, 22 and 23 are connected to the first to third phases of the DC-DC converter respectively, namely the currents flowing through the three windings 21, 22 and 23 are from the first, second and third phases of the DC-DC converter. Further, the direction of the current flowing through the winding 22 is opposite to the direction of the currents flowing through the windings 21 and 23. Caused by the current flowing through the winding 21, a magnetic flux Φ1 flows through the magnetic cover 10 and the magnetic core 11. Caused by the current flowing through the winding 22, a magnetic flux Φ2 flows through the magnetic cores 11 and 12. Caused by the current flowing through the winding 23, a magnetic flux Φ3 flows through the magnetic cores 12 and 13. The relations between the magnetic fluxes Φ1, Φ2 and Φ3 are shown in FIG. 3B. In this embodiment, since the currents flowing through the windings 21 and 22 have opposite directions, the magnetic fluxes Φ1 and Φ2 in the magnetic core 11 have the same direction, and thus the total magnetic flux in the magnetic core 11 is equal to the sum of the magnetic fluxes Φ1 and Φ2. Similarly, since the currents flowing through the windings 22 and 23 have opposite directions, the magnetic fluxes Φ2 and Φ3 in the magnetic core 12 have the same direction, and thus the total magnetic flux in the magnetic core 12 is equal to the sum of the magnetic fluxes Φ2 and Φ3.

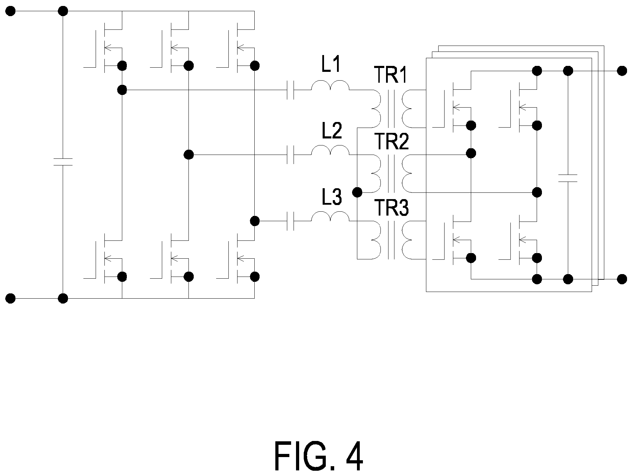

FIG. 4 is a schematic circuit diagram illustrating a three-phase DC-DC converter with the integrated transformer and inductor formed by the modular stacked magnetic component of the present disclosure. Please refer to FIG. 4 in conjunction with FIG. 3A. An inductor L1 and a transformer TR1 of the first phase of the DC-DC converter are an integrated transformer and inductor formed by the magnetic core 11 and winding 21, an inductor L2 and a transformer TR2 of the second phase of the DC-DC converter are an integrated transformer and inductor formed by the magnetic core 12 and winding 22, and an inductor L3 and a transformer TR3 of the third phase of the DC-DC converter are an integrated transformer and inductor formed by the magnetic core 13 and winding 23. In some embodiments of the present disclosure, the three transformers and three inductors in the three-phase DC-DC converter may be constructed using three integrated transformer and inductor. Furthermore, in other embodiments of the present disclosure, the three transformers and inductors can be integrated into a single integrated transformer and inductor.

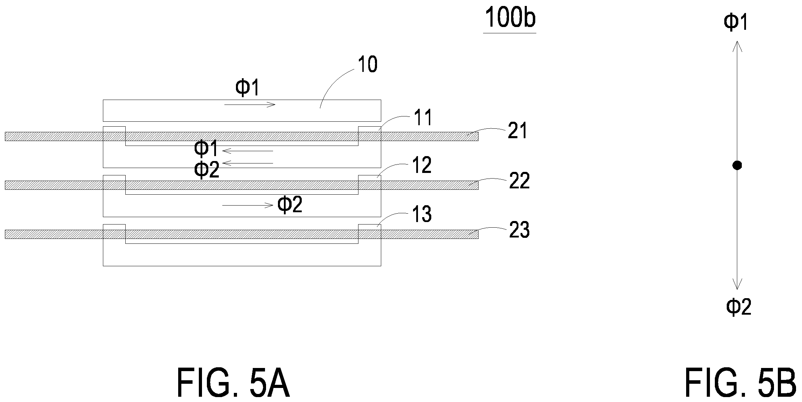

Additionally, in an embodiment, when the DC-DC converter operates in a light load condition, only two of the three phases (the second phase and one of the first and third phases) still operates, so as to improve efficiency. FIG. 5A is a schematic view illustrating a modular stacked magnetic component 100b applied to the three-phase DC-DC converter of FIG. 4 which operates in a light load condition. In this embodiment, in order to improve the efficiency under light load condition, only the first and second phases of the three-phase DC-DC converter operate. Correspondingly, as shown in FIG. 5A, only the magnetic fluxes Φ1 and Φ2 are generated in the magnetic cover 10 and the magnetic cores 11 and 12. The relations between the magnetic fluxes Φ1 and Φ2 are shown in FIG. 5B. Under the light load condition, since only two phases operate, the phase difference of the magnetic fluxes Φ1 and Φ2 is 180 degrees. Therefore, the total magnetic flux in the magnetic core 11, which is equal to the sum of the magnetic fluxes Φ1 and Φ2, is zero or close to zero.

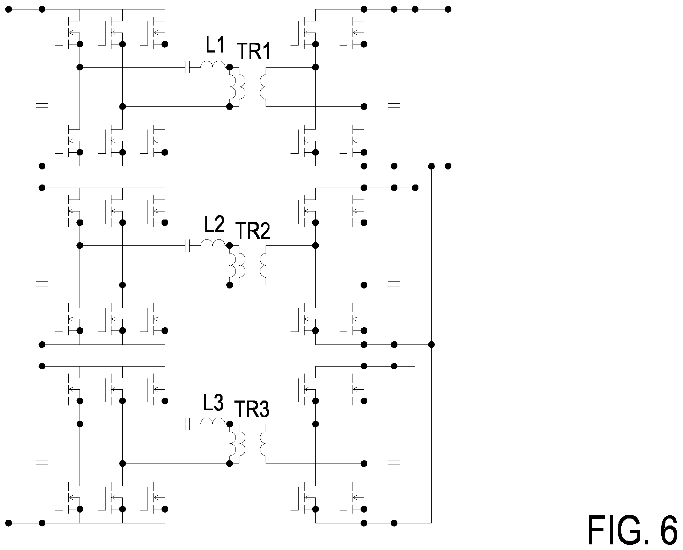

In addition, the three-phase DC-DC converter shown in FIG. 4 includes the coupled three-phase interleaved LLC circuits, while the DC-DC converter which can employ the modular stacked magnetic component of the present disclosure is not limited thereto. For example, as shown in FIG. 6, three-phase DC-DC converter, employing the modular stacked magnetic component of the present disclosure to form the inductors L1, L2 and L3 and transformer TR1, TR2 and TR3, includes the decoupled three-phase interleaved LLC circuits. It is noted that the possible implementation of the DC-DC converter is not limited to the exemplified topologies.

Please refer to FIG. 1 again. In the embodiment of FIG. 1, the magnetic cores 11, 12 and 13 of the modular stacked magnetic component 100 are C-type cores, and the windings 21, 22 and 23 are wound on the side columns of the magnetic cores 11, 12 and 13 (i.e., the side columns of the magnetic cores 11, 12 and 13 serve as winding columns). In particular, the magnetic core 11 includes a plate 110 and two side columns 111, the two side columns 111 are disposed on the plate 110 and are located at two sides of the plate 110, and the winding 21 is wound on the side columns 111. The magnetic core 12 includes a plate 120 and two side columns 121, the two side columns 121 are disposed on the plate 120 and are located at two sides of the plate 120, and the winding 22 is wound on the side columns 121. The magnetic core 13 includes a plate 130 and two side columns 131, the two side columns 131 are disposed on the plate 130 and are located at two sides of the plate 130, and the winding 23 is wound on the side columns 131.

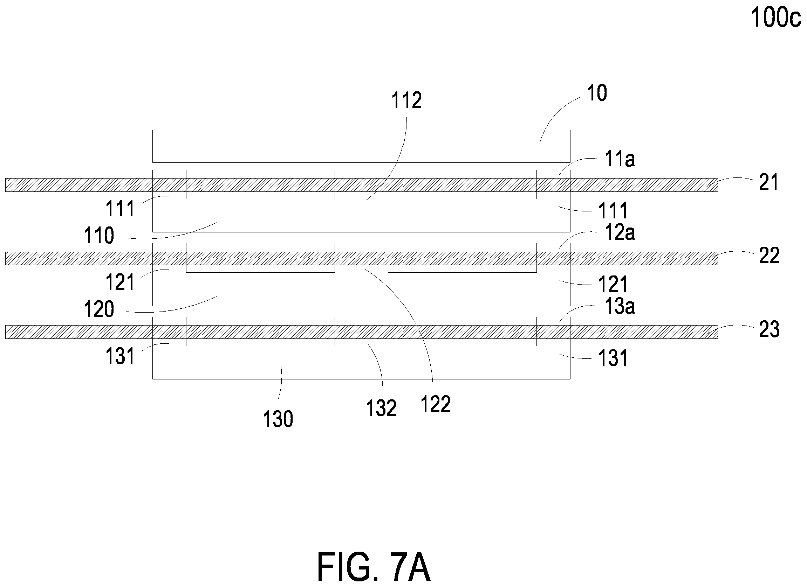

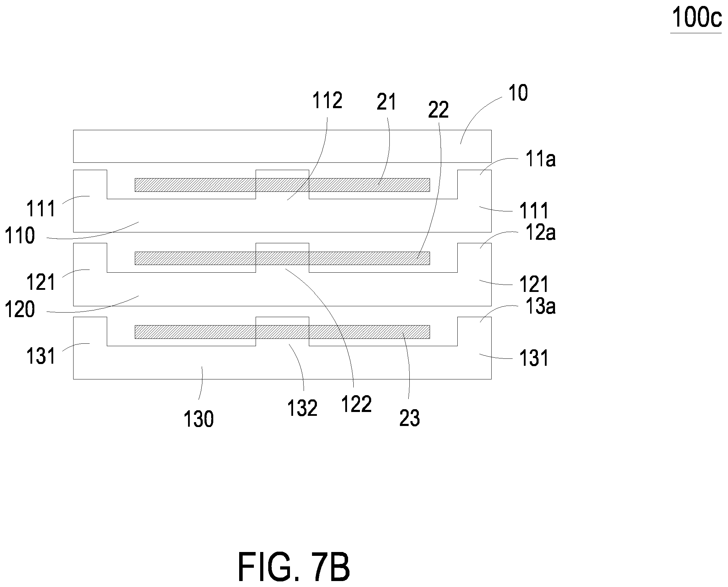

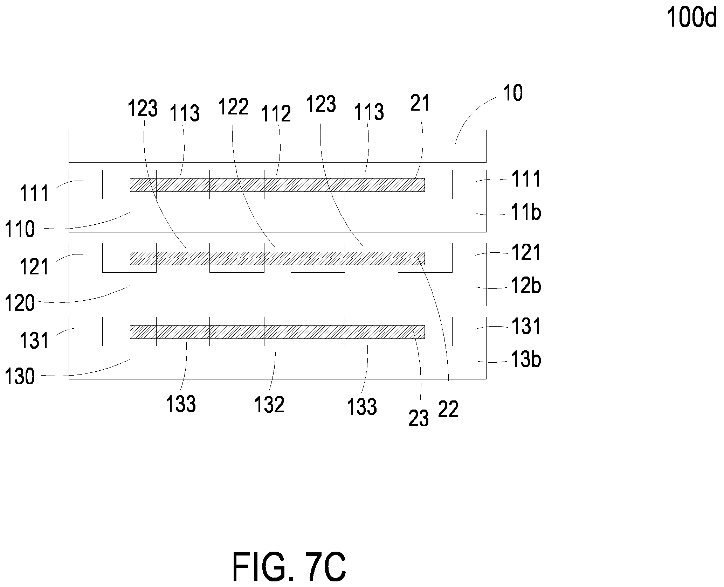

It is noted that the shape of magnetic cores and the winding manner are not limited thereto. For example, the magnetic core may be an E-type core, an U-type core, a T-type core or any other suitable planar core. Meanwhile, the winding may be wound on the center column(s) or any other suitable parts of the magnetic core. FIG. 7A, FIG. 7B and FIG. 7C exemplifies different types of magnetic cores and winding manners.

In the embodiment shown in FIG. 7A, the magnetic cores 11a, 12a and 13a of the modular stacked magnetic component 100c are E-type cores, and the windings 21, 22 and 23 are wound on the center columns and side columns of the magnetic cores 11a, 12a and 13a (i.e., the center columns and side columns of the magnetic cores 11a, 12a and 13a serve as winding columns). In particular, in the modular stacked magnetic component 100c, the magnetic core 11a includes a plate 110, two side columns 111 and a center column 112. The two side columns 111 and the center column 112 are disposed on the plate 110, the two side columns 111 are located at two sides of the plate 110, and the center column 112 is located between the two side columns 111. The windings 21 is wound on the two side columns 111 and the center column 112 of the magnetic core 11a. The magnetic core 12a includes a plate 120, two side columns 121 and a center column 122. The two side columns 121 and the center column 122 are disposed on the plate 120, the two side columns 121 are located at two sides of the plate 120, and the center column 122 is located between the two side columns 121. The windings 22 is wound on the two side columns 121 and the center column 122 of the magnetic core 12a. The magnetic core 13a includes a plate 130, two side columns 131 and a center column 132. The two side columns 131 and the center column 132 are disposed on the plate 130, the two side columns 131 are located at two sides of the plate 130, and the center column 132 is located between the two side columns 131. The windings 23 is wound on the two side columns 131 and the center column 132 of the magnetic core 13a.

In the embodiment shown in FIG. 7B, the structure of the modular stacked magnetic component 100c is the same as that shown in FIG. 7A. The difference between the embodiments of FIG. 7A and FIG. 7B is that in FIG. 7B, the windings 21, 22 and 23 are wound on the center columns 112, 122 and 132 of the magnetic cores 11a, 12a and 13a respectively (i.e., the center columns 112, 122 and 132 of the magnetic cores 11a, 12a and 13a serve as winding columns).

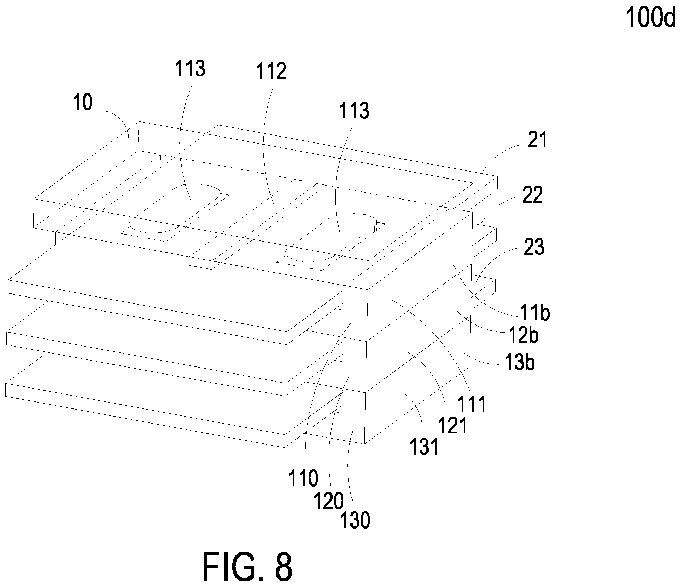

In the embodiment shown in FIG. 7C, each of the magnetic cores 11b, 12b and 13b of the modular stacked magnetic component 100d includes two middle columns and one central column serving as winding columns, and two side columns serving as non-winding columns, and the windings 21, 22 and 23 are wound on the center and middle columns of the magnetic cores 11b, 12b and 13b. The component parts and elements corresponding to those of FIG. 7A are designated by identical numeral references, and detailed descriptions thereof are omitted herein. In particular, in the modular stacked magnetic component 100d, the magnetic core 11b further includes two middle columns 113 disposed on the plate 110. One middle column 113 is located between the center column 112 and one side column 111, and the other middle column 113 is located between the center column 112 and the other side column 111. The windings 21 is wound on the center column 112 and the two middle columns 113 of the magnetic core 11b. The magnetic core 12b further includes two middle columns 123 disposed on the plate 120. One middle column 123 is located between the center column 122 and one side column 121, and the other middle column 123 is located between the center column 122 and the other side column 121. The windings 22 is wound on the center column 122 and the two middle columns 123 of the magnetic core 12b. The magnetic core 13b further includes two middle columns 133 disposed on the plate 130. One middle column 133 is located between the center column 132 and one side column 131, and the other middle column 133 is located between the center column 132 and the other side column 131. The windings 23 is wound on the center column 132 and the two middle columns 133 of the magnetic core 13b. For ease of understanding, a schematic perspective view illustrating an example of the modular stacked magnetic component of FIG. 7C is shown in FIG. 8.

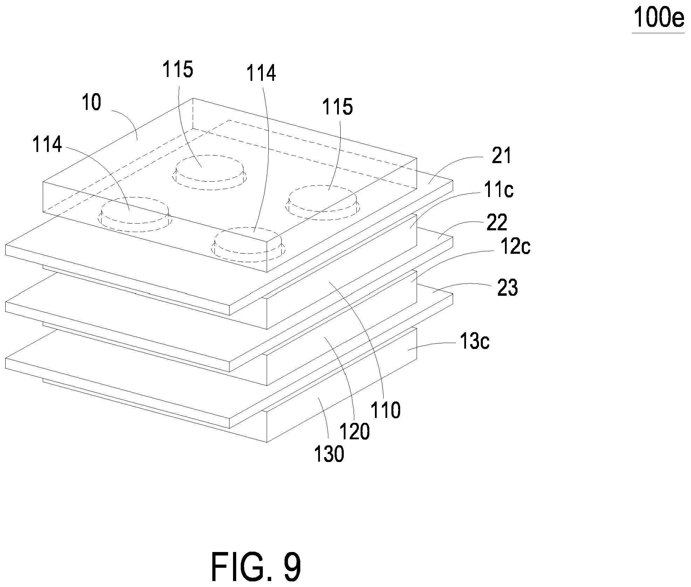

In the above embodiments, the magnetic core always includes side columns. However, the present disclosure is not limited thereto. Please refer to FIG. 9. FIG. 9 is a schematic perspective view illustrating a modular stacked magnetic component including magnetic cores without side columns according to an embodiment of the present disclosure. The component parts and elements corresponding to those of FIG. 8 are designated by identical numeral references, and detailed descriptions thereof are omitted herein. As shown in FIG. 9, each of the magnetic cores 11c, 12c and 13c of the modular stacked magnetic component 100e includes a plate (110, 120, 130) and a plurality of winding columns, and each winding is wound on the plurality of winding columns of the corresponding magnetic core. For example, the magnetic core 11c includes two inductor winding columns 114 and two transformer winding columns 115, the winding 21 is wound on the two inductor winding columns 114 and two transformer winding columns 115 to form an integrated transformer and inductor. Specifically, the winding 21 includes an inductor winding and a transformer winding, the inductor winding of the winding 21 is wound on the two inductor winding columns 114 to form an inductor part of the integrated transformer and inductor, and the transformer winding of the winding 21 is wound on the two transformer winding columns 115 to form a transformer part of the integrated transformer and inductor. In addition, each magnetic core may have inductor air gaps and transformer air gaps between the winding columns thereof and the magnetic cover 10 or another magnetic core disposed on it. For example, the magnetic core 11c has inductor air gaps formed between the inductor winding columns 114 and the magnetic cover 10 and transformer air gaps formed between the transformer winding columns 115 and the magnetic cover 10. Further, the inductor air gaps of the magnetic cores may be the same (with acceptable tolerance), and the transformer air gaps of the magnetic cores may be the same (with acceptable tolerance). The inductor air gap and the transformer air gap may be equal or unequal.

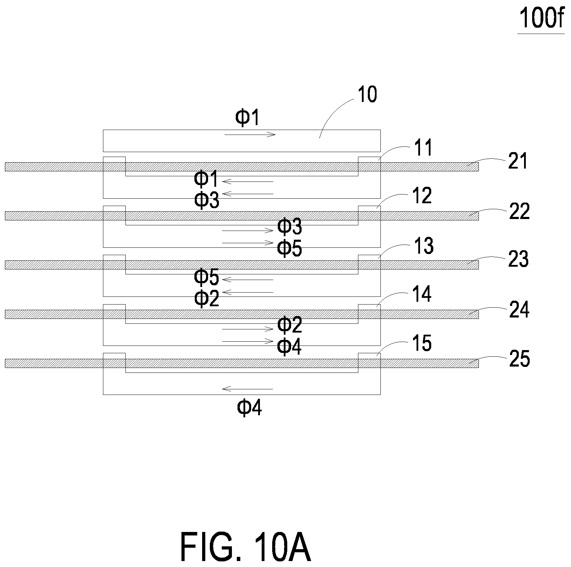

FIG. 10A is a schematic view illustrating a modular stacked magnetic component applied to a five-phase DC-DC converter according to an embodiment of the present disclosure. In FIG. 10A, the component parts and elements corresponding to those of FIG. 1 are designated by identical numeral references, and detailed descriptions thereof are omitted herein. In the five phases of the DC-DC converter, the nth phase is 72 degrees leading the (n+1)th phase, and the fifth phase is 72 degrees leading the first phase. As shown in FIG. 10A, the modular stacked magnetic component 100f includes five magnetic cores 11, 12, 13, 14 and 15, and five windings 21, 22, 23, 24 and 25 wound on the five magnetic cores 11, 12, 13, 14 and 15 respectively. Any two adjacent windings of the five windings 21, 22, 23, 24 and 25 have opposite current directions. The phases of the DC-DC converter connected to the five windings 21, 22, 23, 24 and 25 may be determined according to the phase difference of the magnetic fluxes generated in each magnetic core. For example, in each magnetic core, the phase difference of the magnetic fluxes generated by the currents flowing through the adjacent windings needs to be greater than 90 degrees and less than 270 degrees so that the magnitude of the sum of the magnetic fluxes is reduced. In other words, any two adjacent windings are connected to two phases with a phase difference greater than 90 degrees and less than 270 degrees.

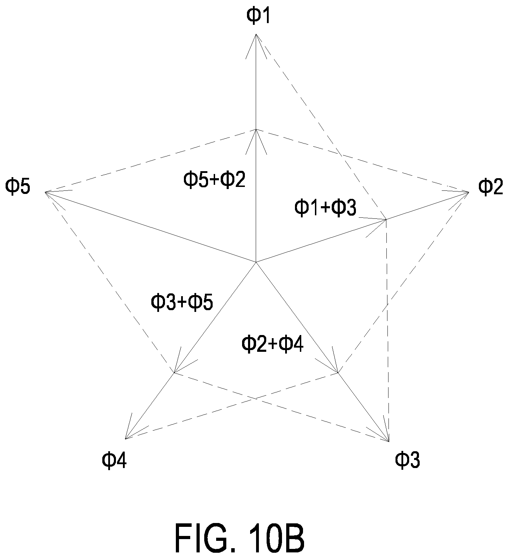

In the embodiment of FIG. 10A, the windings 21, 22, 23, 24 and 25 are connected to the first phase, the third phase, the fifth phase, the second phase and the fourth phase of the DC-DC converter respectively. Caused by the current flowing through the winding 21, a magnetic flux Φ1 flows through the magnetic cover 10 and the magnetic core 11. Caused by the current flowing through the winding 22, a magnetic flux Φ3 flows through the magnetic cores 11 and 12. Caused by the current flowing through the winding 23, a magnetic flux Φ5 flows through the magnetic cores 12 and 13. Caused by the current flowing through the winding 24, a magnetic flux Φ2 flows through the magnetic cores 13 and 14. Caused by the current flowing through the winding 25, a magnetic flux Φ4 flows through the magnetic cores 14 and 15. Accordingly, the total magnetic flux in the magnetic core 11 is equal to the sum of the magnetic fluxes Φ1 and Φ3, the total magnetic flux in the magnetic core 12 is equal to the sum of the magnetic fluxes Φ3 and Φ5, the total magnetic flux in the magnetic core 13 is equal to the sum of the magnetic fluxes Φ5 and Φ2, and the total magnetic flux in the magnetic core 14 is equal to the sum of the magnetic fluxes Φ2 and Φ4. The relations between the magnetic fluxes Φ1, Φ2, Φ3, Φ4 and Φ5 and the said total magnetic fluxes are shown in FIG. 10B.

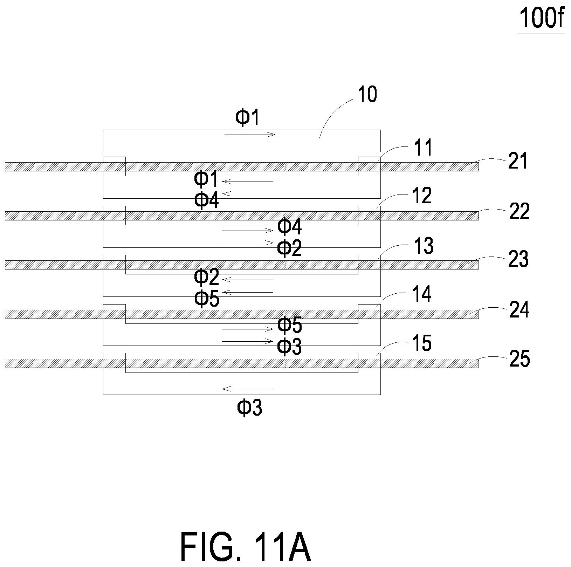

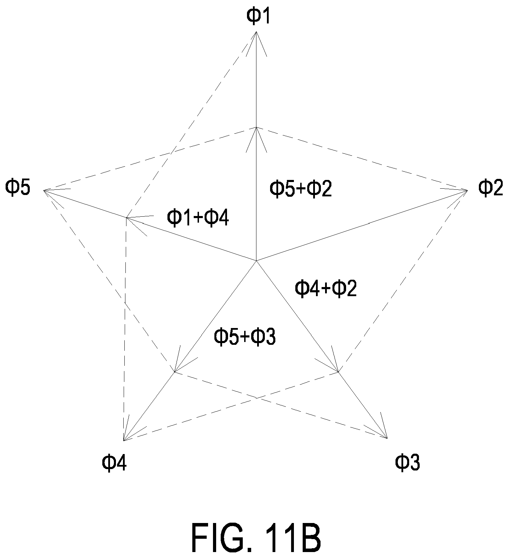

FIG. 11A is a schematic view illustrating a modular stacked magnetic component applied to a five-phase DC-DC converter according to another embodiment of the present disclosure. In FIG. 11A, the component parts and elements corresponding to those of FIG. 10A are designated by identical numeral references, and detailed descriptions thereof are omitted herein. The difference between the embodiments of FIG. 10A and FIG. 11A is the phases of the DC-DC converter connected to the five windings 21, 22, 23, 24 and 25. Particularly, in the embodiment of FIG. 11A, the windings 21, 22, 23, 24 and 25 are connected to the first phase, the fourth phase, the second phase, the fifth phase and the third phase of the DC-DC converter respectively. Caused by the current flowing through the winding 21, a magnetic flux Φ1 flows through the magnetic cover 10 and the magnetic core 11. Caused by the current flowing through the winding 22, a magnetic flux Φ4 flows through the magnetic cores 11 and 12. Caused by the current flowing through the winding 23, a magnetic flux Φ2 flows through the magnetic cores 12 and 13. Caused by the current flowing through the winding 24, a magnetic flux Φ5 flows through the magnetic cores 13 and 14. Caused by the current flowing through the winding 25, a magnetic flux Φ3 flows through the magnetic cores 14 and 15. Accordingly, the total magnetic flux in the magnetic core 11 is equal to the sum of the magnetic fluxes Φ1 and Φ4, the total magnetic flux in the magnetic core 12 is equal to the sum of the magnetic fluxes Φ4 and Φ2, the total magnetic flux in the magnetic core 13 is equal to the sum of the magnetic fluxes Φ2 and Φ5, and the total magnetic flux in the magnetic core 14 is equal to the sum of the magnetic fluxes Φ5 and Φ3. The relations between the magnetic fluxes Φ1, Φ2, Φ3, Φ4 and Φ5 and the said total magnetic fluxes are shown in FIG. 11B.

Based on the exemplified applications of the modular stacked magnetic components in single-phase, three-phase, and five-phase DC-DC converters, the application of the modular stacked magnetic component of the present disclosure can be extended and implemented in DC-DC converters with more phases in the same manner.

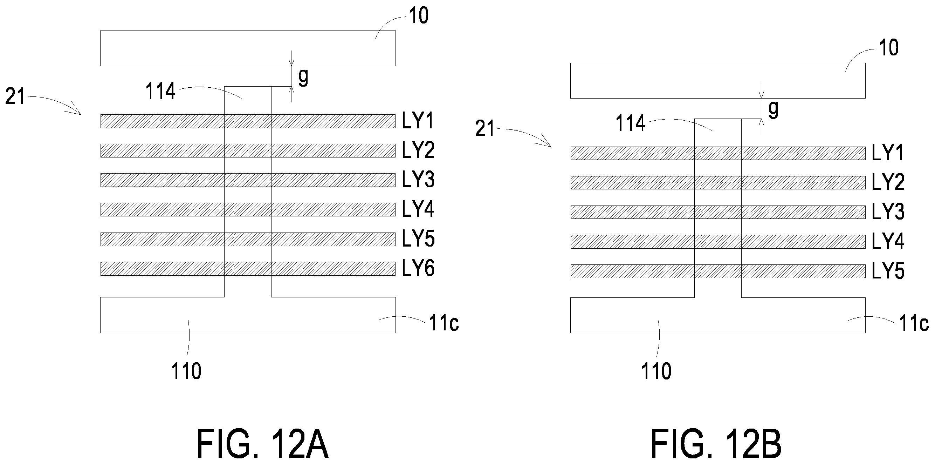

In addition, in the modular stacked magnetic component of the present disclosure, the layers of the winding, which forms an inductor or an inductor part of the integrated transformer and inductor with a corresponding magnetic core, may be arranged in a certain way to reduce the footprint and loss. FIG. 12A and FIG. 12B schematically show two possible implementations of a portion which forms an inductor part of the integrated transformer and inductor in FIG. 9. In specific, FIG. 12A and FIG. 12B show the magnetic cover 10, the winding 21 and the inductor winding column 114 and plate 110 of the magnetic core 11c, and the winding 21 is wound on the inductor winding column 114 to form the inductor part of the integrated transformer and inductor. As shown in FIG. 12A and FIG. 12B, the magnetic core 11c has an air gap g between the inductor winding column 114 and the magnetic cover 10, and the winding 21 wound on the inductor winding column 114 includes M layers, where M is an integer greater than two. For instance, in the M layers of the winding 21, the layer closest to the air gap g is regarded as the first layer LY1, the layer farthest to the air gap g is regarded as the Mth layer LYM, and the first to Mth layers LY1-LYM are stacked vertically on each other in sequence. In an embodiment, if M is even, the layer being the mth closest to the air gap g is electrically connected in parallel to the layer being the mth farthest from the air gap g to form the mth layer set, where m is a positive integer less than or equal to M/2, and all the layer sets are electrically connected in series. Alternatively, if M is odd, the layer being the mth closest to the air gap g is electrically connected in parallel to the layer being the mth farthest from the air gap g to form the mth layer set, where m is a positive integer less than or equal to (M-1)/2, and the layer in the middle (i.e., the ((M+1)/2)th layer) and all the layer sets are electrically connected in series. According to the above manner of connecting the layers of winding, the footprint and winding loss can be reduced.

The difference between the implementations shown in FIG. 12A and FIG. 12B is the number of the layers of winding 21. In FIG. 12A, M is an even number of six. The first layer LY1, which is the closest to the air gap g, is electrically connected in parallel to the sixth layer LY6, which is farthest from the air gap g, to form a first layer set. The second layer LY2, which is the second closest to the air gap g, is electrically connected in parallel to the fifth layer LY5, which is the second farthest from the air gap g, to form a second layer set. The third layer LY3, which is the third closest to the air gap g, is electrically connected in parallel to the fourth layer LY4, which is the third farthest from the air gap g, to form a third layer set. The first to third layer sets are electrically connected in series.

In FIG. 12B, M is an odd number of five. The first layer LY1, which is the closest to the air gap g, is electrically connected in parallel to the fifth layer LY5, which is farthest from the air gap g, to form a first layer set. The second layer LY2, which is the second closest to the air gap g, is electrically connected in parallel to the fourth layer LY4, which is the second farthest from the air gap g, to form a second layer set. The third layer LY3 in the middle, the first layer set and the second layer set are electrically connected in series.

## Claims

1. A modular stacked magnetic component (100) for a DC-DC converter with N phases, wherein N is an odd number greater than 1, in the N phases, an nth phase is 360/N degrees leading an (n+1)th phase, n is a positive integer less than N, an Nth phase is 360/N degrees leading a first phase, and the modular stacked magnetic component (100) is **characterized by** comprising:
N magnetic cores (11, 12, 13) stacked vertically in sequence, wherein each of the N magnetic cores (11) comprises a plate (110) and a plurality of winding columns (111), and the plurality of winding columns (111) are arranged on the plate (110);
a magnetic cover (10) stacked on the top of the N magnetic cores (11, 12, 13); and
N windings (21, 22, 23), connected to the N phases of the DC-DC converter respectively, wherein each of the N windings (21) is wound on the plurality of winding columns (111) of a corresponding magnetic core of the N magnetic cores (11) to form an integrated transformer and inductor;
wherein any two adjacent windings (21, 22), among the N windings, have opposite current directions.

2. The modular stacked magnetic component (100b) according to claim 1, wherein two magnetic fluxes (Φ1, Φ2) generated by any two adjacent windings (21, 22), among the N windings (21, 22, 23), are at least partially canceled out on a plate (110) between the two adjacent windings (21, 22).

3. The modular stacked magnetic component (100b) according to claim 2, wherein a phase difference of the two magnetic fluxes (Φ1, Φ2) is greater than 90 degrees and less than 270 degrees.

4. The modular stacked magnetic component (100) according to claim 3, wherein a thickness of the plate (110) between the two adjacent windings (21, 22) is less than or equal to a thickness of the magnetic cover (10) or the plate (130) of the Nth magnetic core (13) among the N magnetic cores (11, 12, 13).

5. The modular stacked magnetic component (100) according to claim 1, wherein among any two adjacent magnetic cores (11, 12) of the N magnetic cores (11, 12, 13), there is an air gap between the plurality of winding columns (121) of one magnetic core (12) and the plate (110) of the other magnetic core (11).

6. The modular stacked magnetic component (100e) according to claim 5, wherein each of the N windings (21) comprises M layers (LY1-LY6 - FIG. 12A) stacked vertically in sequence, wherein M is an even number greater than two, in the M layers, a mth layer closest to the air gap (g) is electrically connected in parallel to a mth layer farthest from the air gap (g) to form a layer set, m is a positive integer less than or equal to M/2, and all the layer sets are electrically connected in series.

7. The modular stacked magnetic component (100e) according to claim 5, wherein each of the N windings (21) comprises M layers (LY1-LY5 - FIG. 12B) stacked vertically in sequence, wherein M is an odd number greater than two, in the M layers, a mth layer closest to the air gap (g) is electrically connected in parallel to a mth layer farthest from the air gap (g) to form a layer set, m is a positive integer less than or equal to (M-1)/2, and a ((M+1)/2)th layer and all the layer sets are electrically connected in series.

8. The modular stacked magnetic component (100e) according to claim 5, wherein the plurality of winding columns comprise an inductor winding column (114) and a transformer winding column (115), each of the N windings (21) comprises an inductor winding and a transformer winding, the inductor winding is wound on the inductor winding column (114), and the transformer winding is wound on the transformer winding column (115).

9. The modular stacked magnetic component (100e) according to claim 8, wherein among any two adjacent magnetic cores (11c, 12c) of the N magnetic cores, the air gap between the inductor winding column of one magnetic core (12c) and the plate (110) of the other magnetic core (11c) has the same size, and the air gap between the transformer winding column of one magnetic core (12c) and the plate (110) of the other magnetic core (11c) has the same size.

10. The modular stacked magnetic component (100) according to claim 1, wherein the DC-DC converter comprises N-phase interleaved LLC circuits.

11. The modular stacked magnetic component (100) according to claim 1, wherein the N windings (21, 22, 23) comprise N printed circuit board windings.

12. A modular stacked magnetic component (100) for a single-phase DC-DC converter, **characterized by** comprising:
a plurality of magnetic cores (11, 12, 13) stacked vertically in sequence, wherein each of the plurality of magnetic cores (11) comprises a plate (110) and at least one winding column (111), and the at least one winding column (111) is arranged on the plate (110);
a magnetic cover (10) stacked on the top of the plurality of magnetic cores (11, 12, 13); and
a plurality of windings (21, 22, 23), each (21) wound on the at least one winding column (111) of a corresponding magnetic core (11) of the plurality of magnetic cores (11, 12, 13) to form an integrated transformer and inductor, a transformer, or an inductor,
wherein the plurality of windings (21, 22, 23) have a same current direction.

13. The modular stacked magnetic component (100a) according to claim 12, wherein two magnetic fluxes (Φ1, Φ2) generated by any two adjacent windings (21, 22), among the plurality of windings (21, 22, 23), are at least partially canceled out on a plate (110) between the two adjacent windings (21, 22).

14. The modular stacked magnetic component (100) according to claim 13, wherein a thickness of the plate (110) between the two adjacent windings (21, 22) is less than or equal to a thickness of the magnetic cover (10) or the plate (130) of the bottommost magnetic core (13) among the plurality of magnetic cores (11, 12, 13).

15. The modular stacked magnetic component (100) according to claim 12, wherein among any two adjacent magnetic cores (11, 12) of the plurality of magnetic cores (11, 12, 13), there is an air gap between the at least one winding column (121) of one magnetic core (12) and the plate (110) of the other magnetic core (11).

16. The modular stacked magnetic component (100e) according to claim 15, wherein each of the plurality of windings (21) comprises M layers (LY1-LY6 - FIG. 12A) stacked vertically in sequence, wherein M is an even number greater than two, in the M layers, a mth layer closest to the air gap (g) is electrically connected in parallel to a mth layer farthest from the air gap (g) to form a layer set, m is a positive integer less than or equal to M/2, and all the layer sets are electrically connected in series.

17. The modular stacked magnetic component (100e) according to claim 15, wherein each of the plurality of windings (21) comprises M layers (LY1-LY5 - FIG. 12B) stacked vertically in sequence, wherein M is an odd number greater than two, in the M layers, a mth layer closest to the air gap (g) is electrically connected in parallel to a mth layer farthest from the air gap (g) to form a layer set, m is a positive integer less than or equal to (M-1)/2, and a ((M+1)/2)th layer and all the layer sets are electrically connected in series.

18. The modular stacked magnetic component (100e) according to claim 15, wherein the at least one winding column comprises an inductor winding column (114) and a transformer winding column (115), each of the plurality of windings (21) comprises an inductor winding and a transformer winding, the inductor winding is wound on the inductor winding column (114), and the transformer winding is wound on the transformer winding column (115).

19. The modular stacked magnetic component (100e) according to claim 18, wherein among any two adjacent magnetic cores (11c, 12c) of the plurality of magnetic cores, the air gap between the inductor winding column of one magnetic core (12c) and the plate (110) of the other magnetic core (11c) has the same size, and the air gap between the transformer winding column of one magnetic core (12c) and the plate (110) of the other magnetic core (11c) has the same size.

20. The modular stacked magnetic component (100) according to claim 12, wherein the plurality of windings (21, 22, 23) comprise a plurality of printed circuit board windings.
